(19) Europäisches Patentamt
European Patent Office
Office européen des brevets

(11) **EP 3 474 650 B1**

(12) **EUROPÄISCHE PATENTSCHRIFT**

(45) Veröffentlichungstag und Bekanntmachung des Hinweises auf die Patenterteilung:
**09.12.2020   Patentblatt 2020/50**

(21) Anmeldenummer: **17197315.9**

(22) Anmeldetag: **19.10.2017**

(51) Int Cl.:
***H05K 13/08*** *(2006.01)*

(54) **VERFAHREN ZUR ERSTELLUNG EINES RÜSTSATZES FÜR EINE BESTÜCKUNGSMASCHINE**

METHOD FOR PRODUCING A RETROFITTING SET FOR AN ASSEMBLY MACHINE

PROCÉDÉ D'ÉLABORATION D'UN ENSEMBLE D'ADAPTATION POUR UNE MACHINE DE MONTAGE DE COMPOSANTS

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**24.04.2019   Patentblatt 2019/17**

(73) Patentinhaber: **SICK AG**
**79183 Waldkirch (DE)**

(72) Erfinder:
- **Wernet, Danny**
  **79102 Freiburg (DE)**
- **Schmidt, Fabian**
  **79331 Teningen (DE)**
- **Füger, Bernhard**
  **77654 Offenburg (DE)**

(74) Vertreter: **Manitz Finsterwald**
**Patent- und Rechtsanwaltspartnerschaft mbB**
**Martin-Greif-Strasse 1**
**80336 München (DE)**

(56) Entgegenhaltungen:
EP-A1- 0 478 360          DE-A1- 19 834 620
DE-A1-102014 222 936     JP-A- 2017 112 135

**Beschreibung**

Die vorliegende Erfindung betrifft ein Verfahren zur Erstellung eines Rüstsatzes für zumindest eine Bestückungsmaschine.

Die DE 10 2014 222 936 A1 beschreibt ein Verfahren zur Leiterplattenbestückung. Gemäß der Lehre der DE 10 2014 222 936 A1 wird eine Abfolge bestimmt, in welcher verschiedene Rüstungen nacheinander verwendet werden. In diesem Zusammenhang wird beispielsweise das Austauschen von kompletten Rüsttischen gegeneinander beschrieben.

Die EP 0 478 360 A1 offenbart ein Verfahren zur Erstellung eines Rüstsatzes. Dabei werden einem Rüstsatz jeweils die Bauteile hinzugefügt, die das höchste Produktionsvolumen pro belegter Spur erreichen.

Aus der DE 198 34 620 A1 ist ein Verfahren zur Erstellung einer Rüstung bekannt. Gemäß DE 198 34 620 A1 wird bevorzugt eine Festrüstung erzeugt, welche eine ausgeglichene Taktzeit ermöglicht. Alternativ wird eine "Plusrüstung" erzeugt.

Bestückungsmaschinen (d.h. beispielsweise Pick-and-Place-Maschinen oder Bestückungsautomaten) werden in der Fertigung von elektronischen Leiterplatten verwendet, um elektrische bzw. elektronische Bauteile auf der Leiterplatte zu platzieren. Bei den Bauteilen kann es sich z.B. um Widerstände, Kondensatoren, integrierte Schaltkreise (ICs) und dergleichen handeln. Nach dem Platzieren (d.h. dem Bestücken) der Bauteile auf der Leiterplatte mittels der Bestückungsmaschine können die platzierten Bauteile mittels eines Lötverfahrens dauerhaft elektrisch mit der Leiterplatte verbunden werden.

Die elektrischen bzw. elektronischen Bauteile, die von der Bestückungsmaschine platziert werden, werden bei der Bestückungsmaschine üblicherweise in einem Vorrat, einem sogenannten "Feeder" vorgehalten. Neben Feedern können auch z.B. Tabletts mit Vertiefungen für größere ICs (sogenannte "Trays") für das Vorhalten der Bauteile verwendet werden. Mehrere Feeder und/oder Trays können innerhalb eines Wechseltisches angeordnet sein, der in eine Bestückungsmaschine eingeschoben werden kann. Der Wechseltisch umfasst eine begrenzte Kapazität zur Aufnahme verschiedener Bauteile, so dass zur Bestückung verschiedener Baugruppen bzw. Leiterplatten die in dem Wechseltisch vorgehaltenen Bauteile gegebenenfalls verändert werden müssen. Beispielsweise wird ein Satz von Bauteilen in dem Wechseltisch dabei als Rüstsatz für die Bestückungsmaschine bezeichnet.

Muss der Rüstsatz zur Herstellung verschiedener Baugruppen jeweils verändert werden, so entstehen Stillstandszeiten der Bestückungsmaschine, die Kosten verursachen und insbesondere die Herstellungskosten für kleine Stückzahlen von Baugruppen/Leiterplatten in die Höhe treiben.

Herkömmlicherweise wird versucht, anhand von Erfahrung oder "Bauchgefühl" einen Rüstsatz für die Bestückungsmaschine zusammenzustellen, mit welchem idealerweise mehrere verschiedene Baugruppen ohne eine Veränderung des Rüstsatzes hergestellt werden können.

Nachteiligerweise kommt es bei solchen Rüstsätzen trotzdem immer wieder zu Stillstandsphasen der Bestückungsmaschine, in welchen der Rüstsatz der Bestückungsmaschine verändert werden muss.

Es ist daher die der Erfindung zugrundeliegende Aufgabe, ein Verfahren zur Erstellung eines Rüstsatzes für eine Bestückungsmaschine anzugeben, welches Stillstandszeiten minimiert.

Diese Aufgabe wird erfindungsgemäß durch ein Verfahren gemäß Anspruch 1 gelöst.

Erfindungsgemäß wird ein Verfahren zur Erstellung eines Rüstsatzes für zumindest eine Bestückungsmaschine angegeben, wobei die Bestückungsmaschine zum Platzieren von Bauteilen auf/an Baugruppen dient, wobei bei dem Verfahren mittels einer elektronischen Recheneinrichtung

- für eine Vielzahl verschiedener mittels der Bestückungsmaschine herzustellender Baugruppen diejenigen Bauteile ermittelt werden, die für die Baugruppen benötigt werden,
- aus den ermittelten Bauteilen iterativ mögliche Rüstsätze für die Bestückungsmaschine erstellt werden, wobei jeder Rüstsatz mehrere Bauteile umfasst,
- aus den Rüstsätzen ein optimierter Rüstsatz ausgewählt wird.

Anders ausgedrückt werden erfindungsgemäß zunächst die von der Bestückungsmaschine zu verarbeitenden Bauteile (für verschiedene Baugruppen) ermittelt und beispielsweise in einer Liste zusammengestellt. Anschließend werden Kombinationen jeweils mehrerer Bauteile gebildet, d.h. es werden mögliche Rüstsätze erstellt. Abschließend wird aus den möglichen Rüstsätzen ein optimierter Rüstsatz ausgewählt, wobei der optimierte Rüstsatz beispielsweise die Herstellung mehrerer Baugruppen ohne eine Umrüstung oder nur mit sehr geringem Umrüst-Aufwand gestattet.

Die Erfindung setzt dabei auf der Erkenntnis auf, dass die Nachteile der Erstellung eines Rüstsatzes durch "Bauchgefühl" durch die Verwendung einer elektronischen Recheneinrichtung ausgeglichen werden können, da die elektronische Recheneinrichtung die Möglichkeit schafft, eine sehr große Anzahl möglicher Rüstsätze zu evaluieren und somit "durchzuprobieren". Die Erfindung eignet sich daher auch besonders für Elektronikproduktionen, welche eine hohe Varianz unterschiedlicher Baugruppen bei gleichzeitiger geringer Losgröße besitzen. Unter einer Vielzahl von Baugruppen sind zumindest drei Baugruppen, bevorzugt zumindest fünf Baugruppen und besonders bevorzugt zumindest zehn oder einhundert Baugruppen zu verstehen.

Wie erwähnt, werden für das Durchprobieren bevorzugt zunächst sämtliche für die herzustellenden Baugruppen benötigten Bauteile ermittelt. Dabei werden insbesondere die auf der Ober- und Unterseite einer Leiterplatte zu platzierenden Bauteile berücksichtigt. Hierzu können die Bauteile der Baugruppen in eine Liste eingetragen werden, wobei gleiche Bauteile, die in mehreren Baugruppen verwendet werden, bevorzugt nur einmalig eingetragen werden. Anschließend werden verschiedene Kombinationen der ermittelten Bauteile erstellt, wobei insbesonder jeweils maximal so viele Bauteile in einer Kombination enthalten sind, dass die Bauteile von der Bestückungsmaschine aufnehmbar sind, d.h. z.B. in deren Wechseltisch oder Vorrat passen. Schließlich wird aus den so erzeugten Rüstsätzen der optimierte Rüstsatz ausgewählt. Mit dem optimierten Rüstsatz sind dann die Stillstandszeiten reduziert oder können sogar ganz entfallen. Dies ermöglicht deutliche Kosteneinsparungen bei dem Betrieb der Bestückungsmaschine. Außerdem wird es ermöglicht, auch kleine Chargen oder sogar Einzelstücke mit denselben geringen Herstellungskosten zu produzieren, wie Großserien.

Bei der Bestückungsmaschine kann es sich insbesondere auch um eine Straße aus mehreren einzelnen, hintereinander geschalteten Bestückungsmaschinen handeln. In diesem Fall wird auch die Straße als einzelne Bestückungsmaschine angesehen, d.h. es werden jeweils mögliche Rüstsätze und der optimierte Rüstsatz für die gesamte Straße ermittelt und ausgewählt. Ein solcher Rüstsatz kann dann aber eine entsprechend größere Anzahl verschiedener Bauteile enthalten.

Eine Bestückungsmaschine kann auch als Bestückungsautomat oder als Pick-and-Place-Maschine bezeichnet werden. Die Bestückungsmaschine dient, wie vorstehend bereits ausgeführt, bevorzugt zur Leiterplattenfertigung und/oder Bestückung von Leiterplatten mit Elektronikbauteilen. Eine Leiterplatte kann auch als Printed-Circuit-Board (PCB) bezeichnet werden.

Unter einer Baugruppe ist insbesondere eine Leiterplatte mit den darauf zu platzierenden elektronischen Bauteilen zu verstehen. Eine Baugruppe kann eine PCBA (Printed Circuit Board Assembly) sein. Bei den Baugruppen, die bei der Ermittlung der zu verarbeitenden Bauteile berücksichtigt werden, kann es sich insbesondere um diejenigen Baugruppen handeln, die innerhalb eines vorbestimmten Zeitintervalls gefertigt werden sollen. Beispielsweise können die Baugruppen herangezogen werden, die innerhalb der nächsten Woche, des nächsten Monats oder innerhalb des nächsten Quartals zu fertigen sind.

Das erfindungsgemäße Verfahren kann bevorzugt vollständig oder zumindest in Teilen vollautomatisch ausgeführt werden, d.h. ohne Interaktion eines Benutzers. Insbesondere erfolgen die Ermittlung der Bauteile und/oder die Ermittlung der möglichen Rüstsätze vollautomatisch. Auch der optimierte Rüstsatz kann aus den möglichen Rüstsätzen vollautomatisch ausgewählt werden.

Der optimierte Rüstsatz kann angezeigt und/oder ausgegeben werden, woraufhin die Bestückungsmaschine dann mit dem optimierten Rüstsatz bestückt wird. Die Bestückung kann beispielsweise durch einen Bediener der Bestückungsmaschine oder aber auch automatisch mittels eines Roboters erfolgen. Abschließend werden insbesondere die Baugruppen produziert, die mit dem optimierten Rüstsatz herstellbar sind.

Insbesondere kann das erfindungsgemäße Verfahren auch autark ausgeführt werden. Hierbei wird automatisch, z.B. in vorbestimmten Zeitabständen, das Verfahren wiederholt gestartet, um basierend auf den jeweils momentan zu fertigenden Baugruppen einen optimierten Rüstsatz zu bestimmen.

Vorteilhafte Weiterbildungen der Erfindung sind der Beschreibung, der Zeichnung sowie den Unteransprüchen zu entnehmen.

Erfindungsgemäß werden zumindest 10 Millionen ($10^7$), besonders bevorzugt zumindest 10 Milliarden ($10^{10}$), mögliche Rüstsätze erstellt. Auch ist es möglich, eine noch größere Anzahl von möglichen Rüstsätzen zu erstellen, z.B. $10^{12}$ oder $10^{15}$ mögliche Rüstsätze. Durch die iterative Generierung besonders vieler möglicher Rüstsätze wird die Wahrscheinlichkeit erhöht, einen Rüstsatz zu finden, der die Herstellung der Baugruppen ohne eine Veränderung des Rüstsatzes bzw. mit nur sehr geringen Veränderungen des Rüstsatzes ermöglicht.

Erfindungsgemäß sind die Bauteile, die zur Herstellung der am häufigsten zu fertigenden Baugruppe oder der am häufigsten zu fertigenden Baugruppen benötigt werden, in jedem möglichen Rüstsatz enthalten. Anders ausgedrückt, sind die Bauteile der häufigsten Baugruppe(n) fest gesetzt. So können beispielsweise die Bauteile von drei oder fünf (oder von einer anderen vorbestimmten Anzahl) der am häufigsten zu fertigenden Baugruppen in jedem möglichen Rüstsatz enthalten sein. Auf diese Weise wird die Anzahl möglicher Kombinationen für den Rüstsatz und damit die Anzahl der möglichen Rüstsätze deutlich reduziert. Durch die Reduktion der möglichen Kombinationen der Bauteile lassen sich die möglichen Rüstsätze und damit auch der optimierte Rüstsatz mit geringerem Rechenaufwand und/oder in kürzerer Zeit ermitteln.

Generell kann die Erstellung eines möglichen Rüstsatzes als "Ziehen ohne Zurücklegen" angesehen werden, wobei aus der Menge der Bauteile maximal so lange gezogen wird, bis die Kapazität der Bestückungsmaschine erreicht ist. Die Reihenfolge der "gezogenen" Bauteile ist dabei unbeachtlich.

Nachfolgend soll der beispielhafte Fall betrachtet werden, dass mit einer Bestückungsmaschine 650 verschiedene Baugruppen produziert werden sollen, wobei für die Produktion dieser Baugruppen insgesamt 5.000 verschiedene Bauteile benötigt werden. Es wird davon ausgegangen, dass die Bestückungsmaschine 300 verschiedene Bauteile in einem Rüstsatz aufnehmen kann. Anders ausgedrückt wird also 300 Mal aus einer Menge von 5.000 Bauteilen ohne Zurücklegen gezogen. Die Anzahl möglicher Kombinationen bzw. Rüstsätze R für diesen Vorgang berechnet sich nach der Formel

$$R = n!/(k!(n-k)!).$$

Dabei ist n die Anzahl der Bauteile (5.000) und k die Anzahl der gezogenen Bauteile (300). Für die Anzahl der möglichen Rüstsätze R ergibt sich eine Größenordnung von $10^{491}$. Selbst mit heutiger Computertechnik ist es deshalb nicht möglich, alle möglichen Rüstsätze iterativ in vernünftiger Zeit zu ermitteln. Erst durch die Reduktion der möglichen Kombinationen durch die fest gesetzten Bauteile der am häufigsten zu fertigenden Baugruppen wird die Anzahl der möglichen Rüstsätze soweit reduziert, dass beispielsweise 80% oder 100% der dann noch möglichen Rüstsätze für die Bestückungsmaschine iterativ erstellt werden.

Erfindungsgemäss kann als optimierter Rüstsatz derjenige Rüstsatz ausgewählt werden, mit welchem die meisten verschiedenen Baugruppen produziert werden können. Beispielsweise kann also derjenige mögliche Rüstsatz als optimierter Rüstsatz ausgewählt werden, mit welchem z.B. 450 der vorgenannten 650 Baugruppen (ohne eine Veränderung des Rüstsatzes) produziert werden können. Hierzu kann für jeden Rüstsatz ermittelt werden, wie viele Baugruppen mit dem jeweiligen möglichen Rüstsatz produziert werden können. Bevorzugt kann die elektronische Recheneinrichtung bei der iterativen Bestimmung möglicher Rüstsätze jeweils nur denjenigen Rüstsatz temporär abspeichern, mit welchem die meisten verschiedenen Baugruppen produziert werden können. Wird ein neuer Rüstsatz gefunden, der die Produktion einer höheren Anzahl von Baugruppen ermöglicht, so wird der bisher gespeicherte Rüstsatz durch den neuen Rüstsatz ersetzt. Hierdurch können die Speicheranforderungen an die elektronische Recheneinrichtung verringert werden. Ebenso ist es möglich, dass jeweils nur eine vorbestimmte Anzahl der besten möglichen Rüstsätze temporär abgespeichert wird.

Auch kann für die Baugruppen jeweils die voraussichtliche Stückzahl pro Zeiteinheit ermittelt werden, wobei erfindungsgemäss dann als optimierter Rüstsatz derjenige Rüstsatz ausgewählt werden kann, mit welchem die meisten Baugruppen in der Zeiteinheit produziert werden können. Beispielsweise kann dann ein möglicher Rüstsatz als optimierter Rüstsatz ausgewählt werden, mit welchem zwar nur fünf verschiedene Baugruppen gefertigt werden können, wobei diese Baugruppen aber z.B. 95% aller in der Zeiteinheit herzustellenden Baugruppen umfassen.

In entsprechender Weise kann die elektronische Recheneinrichtung auch jeweils nur denjenigen möglichen Rüstsatz abspeichern oder eine vorbestimmte Anzahl der besten möglichen Rüstsätze temporär abspeichern, mit welchem/welchen die meisten Baugruppen in der Zeiteinheit produziert werden können.

Nach der iterativen Erzeugung der möglichen Rüstsätze kann auch zugleich ausgegeben werden, welcher Rüstsatz die Herstellung der meisten verschiedenen Baugruppen und welcher Rüstsatz die Herstellung der meisten Baugruppen ermöglicht. Überdies können jeweils auch z.B. die fünf "besten" Rüstsätze angezeigt bzw. ausgegeben werden.

Gemäß einer weiteren vorteilhaften Ausführungsform nutzen die möglichen Rüstsätze die Aufnahmekapazität der Bestückungsmaschine im Wesentlichen vollständig aus. Dies bedeutet, dass die möglichen Rüstsätze so viele Bauteile enthalten, dass kein weiteres Bauteil mehr im Rüstsatz (und damit in der Bestückungsmaschine) Platz findet.

Elektronische Bauteile werden der Bestückungsmaschine beispielsweise mittels Spulen in einem Feeder, mittels Trays und/oder mittels "Tubes" und insbesondere in dem Wechseltisch bereitgestellt. Die Spulen können abhängig von der Bauteilbreite unterschiedlich breit sein. In Abhängigkeit der Breite der Spule kann die jeweilige Spule eine oder mehrere Anzahlen von Spuren der Bestückungsmaschine belegen. Üblicherweise können die Spulen bzw. die auf den Spulen aufgerollten Gurte eine Breite von 8 mm umfassen, wobei die Bestückungsmaschine (bzw. eine Straße aus mehreren Bestückungsmaschinen) beispielsweise bis zu 320 verschiedene Spuren aufweisen kann und dementsprechend bis zu 320 verschiedene Bauteile in einem Rüstsatz Platz finden können.

Gemäß einer alternativen Ausführungsform nutzen die möglichen Rüstsätze die Aufnahmekapazität der Bestückungsmaschine nur teilweise aus, beispielsweise zu 30%, zu 40%, zu 50%, zu 60%, zu 70%, zu 80% oder zu 90%. Auch wenn der Rüstsatz dann beispielsweise nur 80% der Aufnahmekapazität der Bestückungsmaschine abdeckt, kann davon ausgegangen werden, dass mit diesem Rüstsatz bereits sehr viele verschiedene Baugruppen gefertigt werden können.

Um alle benötigten Baugruppen zu fertigen, können dann die restlichen z.B. 20% der Aufnahmekapazität der Bestückungsmaschine derart bestückt werden, dass die jeweils gerade produzierte Baugruppe gefertigt werden kann ("on-the-fly Bestückung"). Auf diese Weise kann mit sehr geringem Umrüstaufwand eine Produktion sämtlicher Baugruppen ermöglicht werden. Bevorzugt können hierzu wiederum iterativ, basierend auf einem teilweisen Rüstsatz, insbesondere alle, möglichen Herstellungsreihenfolgen der Baugruppen und die damit verbundenen notwendigen Umrüstungen ermittelt werden, wobei dann diejenige Fertigungsreihenfolge ausgewählt wird, die mit den wenigsten Umrüstungen auskommt. Unter einer Umrüstung ist der Austausch eines Bauteils im Wechseltisch der Bestückungsmaschine zu verstehen.

Erfindungsgemäß erfolgen die iterative Bestimmung der möglichen Rüstsätze und/oder die Auswahl des optimierten Rüstsatzes mittels verteilter Computersysteme, beispielsweise mittels Cloud-Computing. Aufgrund der großen Anzahl möglicher Rüstsätze kann eine sehr hohe Rechenleistung benötigt werden, um die möglichen Rüstsätze und/oder den optimierten Rüstsatz zu ermitteln. Durch die Aufteilung der Berechnung auf verschiedene Computersysteme kann die Rechenleistung erhöht und damit die Zeitdauer der Ermittlung des optimierten Rüstsatzes verringert werden. Durch Cloud-Computing können sehr leistungsfähige Computer bei Bedarf hinzugezogen werden. Die Verwendung verteilter Computersysteme ist auf einfache Art und Weise möglich, da der iterative Prozess der Ermittlung möglicher Rüstsätze auf einfache Weise parallelisiert werden kann, beispielsweise mittels "Divide-and-Conquer"-Prinzipien.

Die elektronische Recheneinrichtung kann also mehrere verteilte Computersysteme und insbesondere Cloud-Computer umfassen. Bevorzugt befindet sich die elektronische Recheneinrichtung außerhalb der Bestückungsmaschine und/oder ist von der Bestückungsmaschine getrennt.

Die Parallelisierung der Verarbeitung wird bevorzugt dann vorgenommen, wenn die Erstellung der möglichen Rüstsätze eine vorbestimmte Zeitdauer übersteigen würde. Stellt die elektronische Recheneinrichtung beispielsweise fest, dass die Erstellung der möglichen Rüstsätze voraussichtlich länger als drei Stunden dauern wird, werden zusätzliche Computersysteme zur Erstellung der möglichen Rüstsätze hinzugezogen.

Bevorzugt wird die Erstellung der möglichen Rüstsätze abgebrochen, sobald ein Rüstsatz gefunden ist, mit welchem alle Baugruppen hergestellt werden können. Der Begriff "alle Baugruppen" bezieht sich auf die Baugruppen, die bei der Zusammenstellung der Bauteile berücksichtigt wurden.

Gemäß einer weiteren vorteilhaften Ausführungsform stammen die Informationen über die Bauteile und/oder die Baugruppen von einem Enterprise-Ressource-Planning-(ERP-)System und/oder einem Produktlebenszyklusmanagement-(PLM-)System. In dem ERP- und/oder dem PLM-System können für jede Baugruppe die jeweiligen Bauteile, die Spurbreite der Bauteile, die geplante Stückzahl der Baugruppen pro Zeiteinheit, die voraussichtliche Anzahl von Fertigungsaufträgen für die jeweilige Baugruppe pro Zeiteinheit und/oder zusätzliche Informationen gespeichert sein. Diese Informationen können bei der Ermittlung der möglichen Rüstsätze und bei der Auswahl des optimierten Rüstsatzes herangezogen werden. Dabei kann eine Vernetzung des ERP- und/oder PLM-Systems mit der elektronischen Recheneinrichtung und/oder der Bestückungsmaschine vorhanden sein.

Gemäß einer weiteren vorteilhaften Ausführungsform wird, insbesondere mittels einer Recheneinrichtung der Bestückungsmaschine, die Anordnung und/oder Reihenfolge der Bauteile in dem optimierten Rüstsatz derart optimiert, dass der Zeitaufwand für die Bestückung der Baugruppen minimiert wird. Beispielsweise können Bauteile an von der Bestückungsmaschine schnell zu erreichenden Positionen angeordnet werden, die häufig verwendet werden.

Gemäß einer weiteren vorteilhaften Ausführungsform werden alle oder zumindest ein Teil der in dem optimierten Rüstsatz enthaltenen Bauteile einem Leiterplatten-Entwurfsprogramm mitgeteilt, woraufhin in dem Leiterplatten-Entwurfsprogramm insbesondere jeweils die in dem optimierten Rüstsatz enthaltenen Bauteile bevorzugt verwendet werden. Bei dem Leiterplatten-Entwurfsprogramm kann es sich um ein PCB-(Printed Circuit Board-)Design-Programm, wie z.B. "Eagle CAD" handeln. Auf diese Weise wird eine Rückkopplung des optimierten Rüstsatzes zum Design-Prozess zukünftiger Baugruppen geschaffen, so dass der Entwerfer der Baugruppen bevorzugt die ohnehin im Rüstsatz enthaltenen Bauteile verwendet, wodurch dann eine Veränderung des Rüstsatzes bei der Herstellung neuer Baugruppen vermieden werden kann.

Gemäß einer weiteren vorteilhaften Ausführungsform wird vor dem iterativen Ermitteln möglicher Rüstsätze festgestellt, welche Bauteile in allen Baugruppen oder in einem vorbestimmten Anteil der Baugruppen benötigt werden, wobei die hierbei ermittelten Bauteile in jeden iterativ ermittelten Rüstsatz gesetzt werden. Wird also beispielsweise festgestellt, dass ein Bauteil, z.B. ein Widerstand mit dem Wert 1 k$\Omega$, in sämtlichen Baugruppen verwendet wird, so wird dieses Bauteil fest gesetzt und ist folglich in jedem iterativ ermittelten Rüstsatz enthalten. Auf diese Weise lässt sich die Anzahl der möglichen Rüstsätze stark verringern, wodurch die aufzuwendende Rechenleistung und/oder Zeit deutlich verringert werden kann.

Gemäß einer weiteren vorteilhaften Ausführungsform wird das Verfahren nur für eine vorbestimmte Anzahl der am häufigsten produzierten Baugruppen durchgeführt. Dies bedeutet, das Verfahren wird beispielsweise für fünf oder zehn Baugruppen durchgeführt, deren Stückzahl pro Zeiteinheit am höchsten ist und/oder die pro Zeiteinheit die meisten Fertigungsaufträge besitzen. Durch die Beschränkung auf die am häufigsten produzierten Baugruppen kann ebenfalls eine Reduktion der möglichen Kombinationen und damit eine Verringerung der notwendigen Rechenleistung bzw. notwendigen Zeit erreicht werden.

Gemäß einer weiteren vorteilhaften Ausführungsform wird für zumindest einen iterativ bestimmten Rüstsatz ermittelt, wie oft Bauteile des jeweiligen Rüstsatzes ausgetauscht werden müssten, um alle verschiedenen Baugruppen produzieren zu können. Sofern also beispielsweise kein optimierter Rüstsatz gefunden werden kann, mit dem alle benötigten Baugruppen produziert werden können, kann für zumindest einen iterativ bestimmten Rüstsatz oder für eine vorbestimmte Anzahl iterativ bestimmter Rüstsätze ermittelt werden, wie viele Umrüstungen notwendig sind, um alle Baugruppen produzieren zu können.

Erfindungsgemäss kann dann derjenige Rüstsatz als optimierter Rüstsatz ausgewählt werden, bei welchem die wenigsten Umrüstungen vorgenommen werden müssen, um alle Baugruppen produzieren zu

Gemäß einer weiteren vorteilhaften Ausführungsform wird eine Reihenfolge des Austauschens von Bauteilen des Rüstsatzes und/oder des Herstellens der Baugruppen ermittelt, bei welcher die wenigsten Bauteile ausgetauscht werden müssen, um alle Baugruppen zu produzieren. Hierzu können iterativ auch wieder verschiedene Reihenfolgen des Austauschens von Bauteilen des Rüstsatzes und/oder des Herstellens der Baugruppen durchgespielt werden. Die auf diese Weise gefundene Reihenfolge ermöglicht dann eine effiziente Produktion der Baugruppen mit geringen Stillstandszeiten. Durch die geringen Stillstandszeiten wird zum einen die Bestückungsmaschine effizient ausgenutzt. Zum anderen können Personalkosten, die sonst bei Umrüstungen entstehen, eingespart werden. Gemäß einer weiteren vorteilhaften Ausführungsform wird zur Erstellung der möglichen Rüstsätze und/oder zur Auswahl des optimierten Rüstsatzes ein Algorithmus des maschinellen Lernens eingesetzt, bevorzugt ein künstliches neuronales Netzwerk. Der Algorithmus des maschinellen Lernens kann beispielsweise auch zur Festlegung der Reihenfolge des Austauschens von Bauteilen eines Rüstsatzes bei der Herstellung sämtlicher Baugruppen eingesetzt werden. Insbesondere kann der Algorithmus des maschinellen Lernens mit Informationen über in der Vergangenheit hergestellte Baugruppen und darin verwendete Bauteile trainiert werden, um Vorhersagen und/oder Entscheidungen treffen zu können, welcher Rüstsatz als optimierter Rüstsatz auszuwählen ist.

Weiterhin betrifft die Erfindung eine elektronische Recheneinrichtung gemäß Anspruch 12.

Die Ausführungen zu dem erfindungsgemäßen Verfahren, insbesondere hinsichtlich Vorteilen und bevorzugten Ausführungsformen, gelten für die erfindungsgemäße elektronische Recheneinrichtung entsprechend.

Der erfindungsgemäße Gedanke kann nicht nur für Bestückungsmaschinen eingesetzt werden, sondern kann grundsätzlich im Rahmen industrieller Fertigungsstraßen eingesetzt werden, wobei Fertigungsmaschinen mit Bauteilen versorgt werden, die beispielsweise bei der Automobilproduktion an einem zu fertigenden Automobil bzw. dessen Karosserie angebracht werden.

Die oben getroffenen Ausführungen, insbesondere hinsichtlich Vorteilen gelten für Verfahren mit Fertigungsmaschinen entsprechend.

Nachfolgend wird die Erfindung rein beispielhaft unter Bezugnahme auf die Zeichnung beschrieben. Es zeigt:

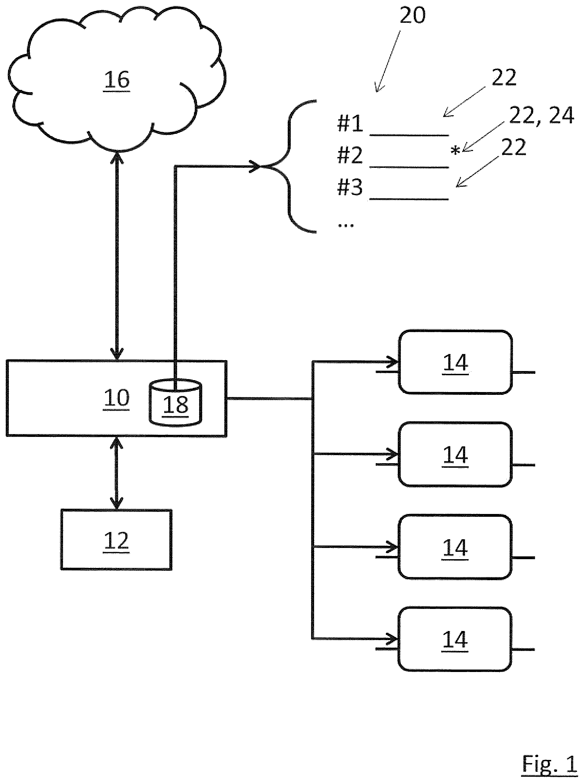

Fig. 1    schematisch ein System mit einer elektronischen Recheneinrichtung und mehreren Bestückungsmaschinen.

Fig. 1 zeigt eine elektronische Recheneinrichtung in der Form eines Steuercomputers 10, welcher mittels einer Datenverbindung mit einem Enterprise-Resource-Planning-(ERP-)System 12 gekoppelt ist. Der Steuercomputer 10 ist mittels einer Datenschnittstelle (nicht gezeigt) mit mehreren Bestückungsmaschinen 14 verbunden.

Der Steuercomputer 10 ist zudem mit mehreren Cloud-Computern 16 über eine Datenverbindung gekoppelt. Der Steuercomputer 10 kann die Cloud-Computer 16 umfassen.

Der Steuercomputer 10 ist ausgebildet von dem ERP-System 12 eine Liste mit innerhalb der nächsten Woche zu fertigenden Baugruppen zu empfangen. Zu jeder Baugruppe übermittelt das ERP-System 12 dem Steuercomputer 10 außerdem die jeweils verwendeten Bauteile und die von der jeweiligen Baugruppe zu fertigende Anzahl. Diese Informationen speichert der Steuercomputer 10 in einem internen Speicher 18 ab.

Überdies erhält der Steuercomputer 10 Informationen über die Bestückungsmaschinen 14, insbesondere über deren Aufnahmekapazität für Bauteile.

Nach dem Erhalt der vorstehend genannten Informationen beginnt der Steuercomputer 10 alle mögliche Rüstsätze 22 für die Bestückungsmaschinen 14 zu erstellen, indem iterativ beliebige Kombinationen der Bauteile aller Baugruppen erstellt werden. Dabei sind in jedem Rüstsatz 22 die Bauteile der fünf am häufigsten zu produzierenden Baugruppen enthalten. Für jeden so erstellten möglichen Rüstsatz 22 wird dann ermittelt, wie viele der herzustellenden Baugruppen mit dem jeweiligen Rüstsatz 22 produzierbar sind und wie hoch die Gesamtanzahl der mit dem jeweiligen Rüstsatz 22 produzierbaren Baugruppen ist. Der Steuercomputer 10 kann mögliche Rüstsätze 22 entweder für jede Bestückungsmaschine 14 separat ermitteln oder alle Bestückungsmaschinen 14 werden als eine Fertigungsstraße angesehen und damit wie eine einzige "große" Bestückungsmaschine 14 behandelt.

Stellt der Steuercomputer 10 fest, dass die Erzeugung der möglichen Rüstsätze 22 länger als eine vorbestimmte Zeitdauer (z.B. drei Stunden) dauern würde, so lagert der Steuercomputer 10 die Erzeugung eines Teils der möglichen Rüstsätze 22 an die Cloud-Computer 16 aus.

Nachdem die möglichen Rüstsätze 22 bestimmt wurden, kann der Steuercomputer 10 eine Rüstsatzliste 20 mit mehreren möglichen Rüstsätzen 22 in dem Speicher 18 abspeichern. Die Rüstsatzliste 20 umfasst auch die Anzahl der mit dem jeweiligen Rüstsatz 22 herstellbaren Baugruppen. Derjenige Rüstsatz 22, mit dem die meisten Baugruppen herstellbar sind, wird dann als optimierter Rüstsatz 24 ausgewählt (in der Fig. 1 mit einem "*" gekennzeichnet).

Der optimierte Rüstsatz 24 wird an die Bestückungsmaschinen 14 übertragen, woraufhin die Bestückungsmaschinen 14 eine Optimierung der Reihenfolge der Bauteile des Rüstsatzes vornehmen, um eine möglichst zeitsparende Produktion der Baugruppen zu ermöglichen. Abschließend werden die Bestückungsmaschinen 14 mit dem optimierten Rüstsatz 24 gerüstet und die Produktion der Baugruppen beginnt. Die Produktion der Baugruppen kann dann idealerweise ohne eine Umrüstung der Bestückungsmaschinen 14 erfolgen.

Bezugszeichenliste

10 Steuercomputer
12 ERP-System
14 Bestückungsmaschine
16 Cloud-Computer
18 Speicher
20 Rüstsatzliste
22 möglicher Rüstsatz
24 optimierter Rüstsatz

**Patentansprüche**

1. Verfahren zur Erstellung eines Rüstsatzes (22, 24) für zumindest eine Bestückungsmaschine (14), wobei die Bestückungsmaschine (14) zum Platzieren von Bauteilen auf/an Baugruppen dient, wobei bei dem Verfahren mittels einer elektronischen Recheneinrichtung (10)

   - für eine Vielzahl verschiedener mittels der Bestückungsmaschine herzustellender Baugruppen diejenigen Bauteile ermittelt werden, die für die Baugruppen benötigt werden,
   - aus den ermittelten Bauteilen mögliche Rüstsätze (22) für die Bestückungsmaschine (14) erstellt werden, wobei jeder Rüstsatz (22) mehrere Bauteile umfasst, wobei jeder Rüstsatz (22) maximal so viele Bauteile enthält, dass die Bauteile von der Bestückungsmaschine (14) aufnehmbar sind,
   - aus den möglichen Rüstsätzen (22) ein optimierter Rüstsatz (24) ausgewählt wird, wobei als optimierter Rüstsatz (24) entweder

      derjenige Rüstsatz (22) ausgewählt wird, mit welchem die meisten verschiedenen Baugruppen produziert werden können, oder
      derjenige Rüstsatz (22) ausgewählt wird, bei welchem die wenigsten Umrüstungen vorgenommen werden müssen, um alle Baugruppen produzieren zu können, oder
      für die Baugruppen jeweils deren voraussichtlicher Stückzahl pro Zeiteinheit ermittelt wird, wobei als optimierter Rüstsatz (24) der mögliche Rüstsatz (22) ausgewählt wird, mit welchem die meisten der in der Zeiteinheit herzustellenden Baugruppen produziert werden können,

   wobei zumindest 10.000.000 mögliche Rüstsätze (22) erstellt werden und die Bestimmung der möglichen Rüstsätze (22) und/oder die Auswahl des optimierten Rüstsatzes (24) mittels verteilter Computersysteme erfolgt, wobei die Bauteile, die zur Herstellung der am häufigsten zu fertigenden Baugruppe oder der am häufigsten zu fertigenden Baugruppen benötigt werden, in jedem möglichen Rüstsatz (22) enthalten sind.

2. Verfahren nach Anspruch 1,
   **dadurch gekennzeichnet, dass**
   zumindest 10.000.000.000 mögliche Rüstsätze (22) erstellt werden.

3. Verfahren nach zumindest einem der vorstehenden Ansprüche,
   **dadurch gekennzeichnet, dass**
   die möglichen Rüstsätze (22) die Aufnahmekapazität der Bestückungsmaschine (14) nur teilweise ausnutzen, beispielsweise zu 80%.

4. Verfahren nach zumindest einem der vorstehenden Ansprüche,
   **dadurch gekennzeichnet, dass**
   die Bestimmung der möglichen Rüstsätze (22) und/oder die Auswahl des optimierten Rüstsatzes (24) mittels Cloud-Computing (16) erfolgt.

5. Verfahren nach zumindest einem der vorstehenden Ansprüche,
   **dadurch gekennzeichnet, dass**
   die Informationen über die Bauteile und/oder die Baugruppen von einem Enterprise Resource Planning (ERP)-System (12) und/oder einem Produktlebenszyklusmanagement (PLM)-System stammen.

6. Verfahren nach zumindest einem der vorstehenden Ansprüche,
   **dadurch gekennzeichnet, dass**
   die in dem optimierten Rüstsatz (24) enthaltenen Bauteile einem Leiterplatten-Entwurfsprogramm mitgeteilt werden, woraufhin in dem Leiterplatten-Entwurfsprogramm insbesondere jeweils die in dem optimierten Rüstsatz (24) enthaltenen Bauteile bevorzugt verwendet werden.

7. Verfahren nach zumindest einem der vorstehenden Ansprüche,
   **dadurch gekennzeichnet, dass**
   vor dem Ermitteln möglicher Rüstsätze (22) festgestellt wird, welche Bauteile in allen Baugruppen oder in einem vorbestimmten Teil der Baugruppen benötigt werden, wobei die hierbei ermittelten Bauteile in jeden ermittelten möglichen Rüstsatz (22) gesetzt werden.

8. Verfahren nach zumindest einem der vorstehenden Ansprüche,
**dadurch gekennzeichnet, dass**
das Verfahren nur für eine vorbestimmte Anzahl der am häufigsten produzierten Baugruppen durchgeführt wird.

9. Verfahren nach zumindest einem der vorstehenden Ansprüche,
**dadurch gekennzeichnet, dass**
für zumindest einen bestimmten möglichen Rüstsatz (22) ermittelt wird, wie oft ein Bauteil des jeweiligen Rüstsatzes (22) ausgetauscht werden müsste, um alle Baugruppen zu produzieren.

10. Verfahren nach Anspruch 9,
**dadurch gekennzeichnet, dass**
eine Reihenfolge des Austauschens von Bauteilen des Rüstsatzes (22) und/oder des Herstellens der Baugruppen ermittelt wird, bei welcher die wenigsten Bauteile ausgetauscht werden müssen, um alle Baugruppen zu produzieren.

11. Verfahren nach zumindest einem der vorstehenden Ansprüche,
**dadurch gekennzeichnet, dass**
zur Erstellung der möglichen Rüstsätze (22) und/oder zur Auswahl des optimierten Rüstsatzes (24) ein Algorithmus des maschinellen Lernens eingesetzt wird, bevorzugt ein künstliches neuronales Netzwerk.

12. Elektronische Recheneinrichtung (10) umfassend mehrere verteilte Computersysteme und eine Datenschnittstelle, wobei die Recheneinrichtung ausgebildet ist,

- für eine Vielzahl verschiedener mittels einer Bestückungsmaschine (14) herzustellender Baugruppen diejenigen Bauteile zu ermitteln, die für die Baugruppen benötigt werden,
- aus den ermittelten Bauteilen mögliche Rüstsätze (22) für die Bestückungsmaschine zu erstellen, wobei jeder mögliche Rüstsatz (22) mehrere Bauteile umfasst, wobei jeder Rüstsatz (22) maximal so viele Bauteile enthält, dass die Bauteile von der Bestückungsmaschine (14) aufnehmbar sind,
- aus den möglichen Rüstsätzen (22) einen optimierten Rüstsatz (24) auszuwählen, wobei als optimierter Rüstsatz (24) entweder

derjenige Rüstsatz (22) ausgewählt wird, mit welchem die meisten verschiedenen Baugruppen produziert werden können, oder
derjenige Rüstsatz (22) ausgewählt wird, bei welchem die wenigsten Umrüstungen vorgenommen werden müssen, um alle Baugruppen produzieren zu können,
oder
für die Baugruppen jeweils deren voraussichtlicher Stückzahl pro Zeiteinheit ermittelt wird, wobei als optimierter Rüstsatz (24) der mögliche Rüstsatz (22) ausgewählt wird, mit welchem die meisten der in der Zeiteinheit herzustellenden Baugruppen produziert werden können,

- den optimierten Rüstsatz (24) mittels der Datenschnittstelle auszugeben,
- zumindest 10.000.000 mögliche Rüstsätze (22) zu erstellen,
- die Bestimmung der möglichen Rüstsätze (22) und/oder die Auswahl des optimierten Rüstsatzes (24) mittels der verteilten Computersysteme vorzunehmen, und
- die Bauteile, die zur Herstellung der am häufigsten zu fertigenden Baugruppe oder der am häufigsten zu fertigenden Baugruppen benötigt werden, in jedem möglichen Rüstsatz (22) vorzusehen.

## Claims

1. A method of preparing a setup kit (22, 24) for at least one placement machine (14), wherein the placement machine (14) serves for the placement of components on/at assemblies; and wherein, in the method, by means of an electronic processing device (10),

- those components that are required for the assemblies are determined for a plurality of different assemblies to be manufactured by means of the placement machine;
- possible setup kits (22) for the placement machine (14) are prepared from the determined components, with each setup kit (22) comprising a plurality of components, and with each setup kit (22) including at most so many components that the components can be received by the placement machine (14);
- an optimized setup kit (24) is selected from the possible setup kits (22), wherein either

that possible setup kit (22) is selected as the optimized set-up kit (24) with which the most different assemblies can be produced or
that setup kit (22) is selected as the optimized setup kit (24) in which the fewest setup changes have to be carried out to be able to produce all the assemblies
or
the respective probable volume per time unit is determined for the assemblies, with that possible setup kit (22) being selected as the optimized setup kit (24) with which the most assemblies to be manufactured in the time unit can be produced; wherein at least 10,000,000 possible setup kits (22) are prepared and the determination of the possible setup kits (22) and/or the selection of the optimized setup kit (24) takes/take place by means of distributed computer systems; and wherein the components that are required for manufacturing the assembly or assemblies to be produced most frequently are included in every possible setup kit (22).

2. A method in accordance with claim 1, **characterized in that** at least 10,000,000,000 possible setup kits (22) are prepared.

3. A method in accordance with at least one of the preceding claims, **characterized in that** the possible setup kits (22) only utilize the intake capacity of the placement machine in part, for example 80%.

4. A method in accordance with at least one of the preceding claims, **characterized in that** the determination of the possible setup kits (22) and/or the selection of the optimized setup kit (24) takes/take place by means of cloud computing (16).

5. A method in accordance with at least one of the preceding claims, **characterized in that** the information on the components and/or on the assemblies comes from an enterprise resource planning system (ERP system) (12) and/or from a product lifecycle management system (PLM system).

6. A method in accordance with at least one of the preceding claims, **characterized in that** the components included in the optimized setup kit (24) are communicated to a circuit board design program, whereupon in particular the respective components included in the optimized setup kit (24) are preferably used in the circuit board design program.

7. A method in accordance with at least one of the preceding claims, **characterized in that** it is determined which components are required in all the assemblies or in a predetermined proportion of the assemblies before the determination of possible setup kits (22), with the components determined in this process being set in each determined possible setup kit (22).

8. A method in accordance with at least one of the preceding claims, **characterized in that** the method is only carried out for a predefined number of the assemblies produced the most frequently.

9. A method in accordance with at least one of the preceding claims, **characterized in that** it is determined for at least one determined possible setup kit (22) how often a component of the respective setup kit (22) would have to be replaced to produce all the assemblies.

10. A method in accordance with claim 9, **characterized in that** a sequence of the replacement of components of the setup kit (22) and/or of the manufacture of the assemblies is determined in which the fewest components have to be replaced to produce all the assemblies.

11. A method in accordance with at least one of the preceding claims, **characterized in that** an algorithm of machine learning, preferably an artificial neuronal network, is used to prepare the possible setup kits (22) and/or to select the optimized setup kit (24).

12. An electronic processing device (10) comprising a plurality of distributed computer systems and a data interface, wherein the processing device is configured

    - to determine those components that are required for the assemblies for a plurality of different assemblies to be manufactured by means of a placement machine (14);
    - to prepare possible setup kits (22) for the placement machine from the determined components, with each possible setup kit (22) comprising a plurality of components, and with each setup kit (22) including at most so many components that the components can be received by the placement machine (14);
    - to select an optimized setup kit (24) from the possible setup kits (22), wherein either

        that possible setup kit (22) is selected as the optimized set-up kit (24) with which the most different assemblies can be produced or

that setup kit (22) is selected as the optimized setup kit (24) in which the fewest setup changes have to be carried out to be able to produce all the assemblies

or

the respective probable volume per time unit is determined for the assemblies, with that possible setup kit (22) being selected as the optimized setup kit (24) with which the most assemblies to be manufactured in the time unit can be produced;

- to output the optimized setup kit (24) by means of the data interface;
- to prepare at least 10,000,000 possible setup kits (22);
- to perform the determination of the possible setup kits (22) and/or the selection of the optimized setup kit (24) by means of the distributed computer systems; and
- to provide the components that are required for manufacturing the assembly or assemblies to be produced most frequently in every possible setup kit (22).

**Revendications**

1. Procédé pour créer un jeu d'équipements (22, 24) pour au moins une machine de montage de composants (14), la machine de montage de composants (14) étant utilisée pour placer des composants sur/au niveau de groupes structurels, procédé dans lequel, au moyen d'un dispositif de calcul électronique (10),

- pour une multitude de groupes structurels différents à réaliser au moyen de la machine de montage de composants, on détermine ceux des composants qui sont nécessaires aux groupes structurels,
- à partir des composants déterminés, on crée des jeux d'équipements possibles (22) pour la machine de montage de composants (14), chaque jeu d'équipements (22) comprenant plusieurs composants, chaque jeu d'équipements (22) comprenant au maximum un nombre de composants tel que les composants peuvent être reçus par la machine de montage de composants (14),
- parmi les jeux d'équipements possibles (22), on sélectionne un jeu d'équipements optimisé (24), et on sélectionne comme jeu d'équipements optimisé (24)

soit le jeu d'équipements (22) avec lequel on peut produire le plus grand nombre de groupes structurels différents,

soit le jeu d'équipements (22) pour lequel le moins de rééquipements sont nécessaires pour pouvoir produire tous les groupes structurels, soit encore on détermine pour les groupes structurels le nombre prévisible de pièces par unité de temps, et on sélectionne comme jeu d'équipements optimisé (24) le jeu d'équipements possible (22) avec lequel le plus grand nombre de groupes structurels à réaliser dans l'unité de temps peuvent être produits,

et on crée au moins 10.000.000 de jeux d'équipements possibles (22), et on définit les jeux d'équipements possibles (22) et/ou on sélectionne le jeu d'équipements optimisé (24) à l'aide de systèmes informatiques répartis, les composants qui sont nécessaires pour réaliser le groupe structurel à fabriquer le plus fréquemment ou les groupes structurels à fabriquer le plus fréquemment étant contenus dans chaque jeu d'équipements possible (22).

2. Procédé selon la revendication 1,
   **caractérisé en ce que**
   on crée au moins 10.000.000.000 de jeux d'équipements possibles (22).

3. Procédé selon l'une au moins des revendications précédentes,
   **caractérisé en ce que**
   les jeux d'équipements possibles (22) n'exploitent que partiellement la capacité de réception de la machine de montage de composants (14), par exemple à 80%.

4. Procédé selon l'une au moins des revendications précédentes,
   **caractérisé en ce que**
   la définition des jeux d'équipements possibles (22) et/ou la sélection du jeu d'équipements optimisé (24) s'effectue(nt) au moyen de l'informatique en nuage dite « Cloud-Computing » (16).

5. Procédé selon l'une au moins des revendications précédentes,
   **caractérisé en ce que**
   les informations sur les composants et/ou sur les groupe structurels proviennent d'un système de planification des ressources de l'entreprise (ERP) (12) et/ou d'un système de gestion du cycle de vie des produits (PLM).

6. Procédé selon l'une au moins des revendications précédentes,
   **caractérisé en ce que**
   les composants contenus dans le jeu d'équipements optimisé (24) sont communiqués à un programme de conception de carte de circuit imprimé, suite à quoi on utilise dans le programme de conception de carte de circuit imprimé de préférence en particulier les composants contenus dans le jeu d'équipements optimisé (24).

7. Procédé selon l'une au moins des revendications précédentes,
**caractérisé en ce que**
avant de déterminer des jeux d'équipements possibles (22), on constate quels composants sont nécessaires dans tous les groupes structurels ou dans une partie prédéterminée des groupes structurels, les composants ainsi déterminés étant placés dans chaque jeu d'équipements possible (22) déterminé.

8. Procédé selon l'une au moins des revendications précédentes,
**caractérisé en ce que**
le procédé n'est mis en œuvre que pour un nombre prédéterminé de groupes structurels les plus fréquemment produits.

9. Procédé selon l'une au moins des revendications précédentes,
**caractérisé en ce que**
pour au moins un jeu d'équipements possible (22) défini, on détermine la fréquence à laquelle un composant du jeu d'équipements respectif (22) devrait être interchangé afin de produire tous les groupes structurels.

10. Procédé selon la revendication 9,
**caractérisé en ce que**
on détermine une succession d'interchangement de composants du jeu d'équipements (22) et/ou de production de groupes structurels, selon laquelle il faut interchanger le moins de composants possible pour produire tous les groupes structurels.

11. Procédé selon l'une au moins des revendications précédentes,
**caractérisé en ce que**
on utilise un algorithme d'apprentissage automatique, de préférence un réseau neuronal artificiel, pour créer les jeux d'équipements possibles (22) et/ou pour sélectionner le jeu d'équipements optimisé (24).

12. Dispositif de calcul électronique (10) comprenant plusieurs systèmes informatiques répartis et une interface de données, le dispositif de calcul étant réalisé pour

- déterminer ceux des composants qui sont nécessaires aux groupes structurels pour une multitude de groupes structurels différents à réaliser au moyen d'une machine de montage de composants (14),
- à partir des composants déterminés, créer des jeux d'équipements possibles (22) pour la machine de montage de composants, chaque jeu d'équipements possible (22) comprenant plusieurs composants, chaque jeu d'équipements (22) contenant au maximum un nombre de composants tel que les composants peuvent être reçus par la machine de montage de composants (14),
- sélectionner un jeu d'équipements optimisé (24) parmi les jeux d'équipements possibles (22), en sélectionnant comme jeu d'équipements optimisé (24)

soit le jeu d'équipements (22) avec lequel on peut produire le plus grand nombre de groupes structurels différents,
soit le jeu d'équipements (22) pour lequel le moins de rééquipements sont nécessaires pour pouvoir produire tous les groupes structurels, soit encore en déterminant pour les groupes structurels le nombre prévisible de pièces par unité de temps, et en sélectionnant comme jeu d'équipements optimisé (24) le jeu d'équipements possible (22) avec lequel le plus grand nombre de groupes structurels à réaliser dans l'unité de temps peuvent être produits,

- émettre le jeu d'équipements optimisé (24) via l'interface de données,
- créer au moins 10.000.000 de jeux d'équipements possibles (22),
- définir les jeux d'équipements possibles (22) et/ou sélectionner le jeu d'équipements optimisé (24) à l'aide des systèmes informatiques répartis, et
- prévoir dans chaque jeu d'équipements possible (22) les composants qui sont nécessaires pour réaliser le groupe structurel à fabriquer le plus fréquemment ou les groupes structurels à fabriquer le plus fréquemment.

Fig. 1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102014222936 A1
- EP 0478360 A1

- DE 19834620 A1